# EUROPEAN PATENT SPECIFICATION

(11) **EP 2 953 004 B1**
(45) Date of publication and mention of the grant of the patent: **26.09.2018**
(21) Application number: 15169252.2
(22) Date of filing: 26.05.2015
(51) Int. Cl.: G06F 1/32, H03K 19/00

(54) **ENERGY-RECYCLING FOR A COST-EFFECTIVE PLATFORM TO OPTIMIZE ENERGY EFFICIENCY FOR LOW POWERED SYSTEM**
ENERGIEVERWERTUNG FÜR EINE KOSTENEFFEKTIVE PLATTFORM ZUR OPTIMIERUNG DER ENERGIEEFFIZIENZ FÜR EIN SYSTEM MIT NIEDRIGEM STROMVERBRAUCH
RECYCLAGE D'ÉNERGIE POUR UNE PLATE-FORME ÉCONOMIQUE AFIN D'OPTIMISER L'EFFICACITÉ ÉNERGÉTIQUE D'UN SYSTÈME À FAIBLE PUISSANCE

(30) Priority: 02.06.2014 WO PCT/US2014/293785
(43) Date of publication of application: 09.12.2015
(73) Proprietor: NXP B.V., 5656 AE Eindhoven (NL)
(72) Inventor: KAPOOR, Ajay, 5656AA Eindhoven (NL); MALZAHN, Ralf, 22529 Hamburg (DE); SHARMA, Vibhu, 5656AA Eindhoven (NL); PINEDA DE GYVEZ, Jose de Jesus, 5656AA Eindhoven (NL); THUERINGER, Peter, A-8101 Gratkorn (AT)
(74) Representative: Krott, Michel

(56) References cited:
- WO-A2-2004/102628
- S. RAJAPANDIAN ET AL: "High-Voltage Power Delivery Through Charge Recycling", IEEE JOURNAL OF SOLID-STATE CIRCUITS, vol. 41, no. 6, 1 June 2006 (2006-06-01), pages 1400-1410, XP055082469, ISSN: 0018-9200, DOI: 10.1109/JSSC.2006.874314
- UEDA KAZUHIRO ET AL: "Low-Power On-Chip Charge-Recycling DC-DC Conversion Circuit and System", IEEE JOURNAL OF SOLID-STATE CIRCUITS, IEEE SERVICE CENTER, PISCATAWAY, NJ, USA, vol. 48, no. 11, 1 November 2013 (2013-11-01), pages 2608-2617, XP011531059, ISSN: 0018-9200, DOI: 10.1109/JSSC.2013.2274829 [retrieved on 2013-10-21]
- KAUSHIK MAZUMDAR ET AL: "Charge recycling on-chip DC-DC conversion for near-threshold operation", SUBTHRESHOLD MICROELECTRONICS CONFERENCE (SUBVT), 2012 IEEE, IEEE, 9 October 2012 (2012-10-09), pages 1-3, XP032301786, DOI: 10.1109/SUBVT.2012.6404322 ISBN: 978-1-4673-1586-9

## Description

### TECHNICAL FIELD

Various exemplary embodiments disclosed herein relates generally to energy recycling for a cost-effective platform to optimize energy efficiency for low powered systems.

### BACKGROUND

Low power design realization is a common challenge faced by various applications. With the advent of a new era of applications such as wireless energy based systems, Internet-of-things (IoT), *etc*., energy consumption of a design is becoming the most important specifications. This is in contrast to various somewhat traditional applications like computers, laptops, mobile phones *etc.* where power consumption was important but timing and area specifications were most important. It is also important to realize that often energy consumption in static modes, where leakage occurs, are equally or more important than dynamic energy consumption of a design. Moreover, these problems may be aggravated by the shrinking circuit technologies, where, leakages increase with each device and limited voltage scalability of memories. Given the limited energy budget various systems, there remains a need to explore new design techniques to maximize the energy utilization.

Document WO 2004/102628 discloses a system comprising voltage regulators and stacked logic blocks. A number of capacitors are connected between the stacked logic blocks so as to store small charge imbalances for reuse. Large charge imbalances are adjusted by the voltage regulators sinking or sourcing current to the node between the stacked logic blocks.

### SUMMARY

A brief summary of various exemplary embodiments is presented below. Some simplifications and omissions may be made in the following summary, which is intended to highlight and introduce some aspects of the various exemplary embodiments, but not to limit the scope of the invention. Detailed descriptions of an exemplary embodiment adequate to allow those of ordinary skill in the art to make and use the inventive concepts will follow in later sections.

Various exemplary embodiments relate to a system according to independent claim 1.

Further, various exemplary embodiments relate to a method according to independent claim 7.

### BRIEF DESCRIPTION OF THE DRAWINGS

In order to better understand various exemplary embodiments, reference is made to the accompanying drawings, wherein:
FIG. 1 illustrates a generic system using magnetic coupling to transfer wireless energy;
FIG.2 illustrates a low power system that may be powered using a power source;
FIG. 3 illustrates a stacked circuit system according to the related art;
FIG. 4 illustrates a system that implements a charge-recycling between memory and digital circuits;
FIG. 5 illustrates a system with a level shifter; and
FIG. 6 illustrates the various inputs and outputs associated with the level shifter of FIG. 5.

To facilitate understanding, identical reference numerals have been used to designate elements having substantially the same or similar structure and/or substantially the same or similar function.

### DETAILED DESCRIPTION

The description and drawings illustrate the principles of the invention. It will thus be appreciated that those skilled in the art will be able to devise various arrangements that, although not explicitly described or shown herein, embody the principles of the invention. Furthermore, all examples recited herein are principally intended expressly to be for pedagogical purposes to aid the reader in understanding the principles of the invention and the concepts contributed by the inventor(s) to furthering the art, and are to be construed as being without limitation to such specifically recited examples and conditions. Additionally, the term, "or," as used herein, refers to a non-exclusive or (i.e., and/or), unless otherwise indicated (e.g., "or else" or "or in the alternative"). Also, the various embodiments described herein are not necessarily mutually exclusive, as some embodiments can be combined with one or more other embodiments to form new embodiments. As used herein, the terms "context" and "context object" will be understood to be synonymous, unless otherwise indicated.

Wireless energy transfer was first envisioned by Nikola Tesla, but recent technological advancements have led to a renewed interest in this concept. In systems where wireless energy transfer is used, the power available is limited and needs to be used as efficiently as possible. As a result, systems powered by wireless energy transfer provide an example of a system that will benefit from the embodiments described below that provide increased energy utilization.

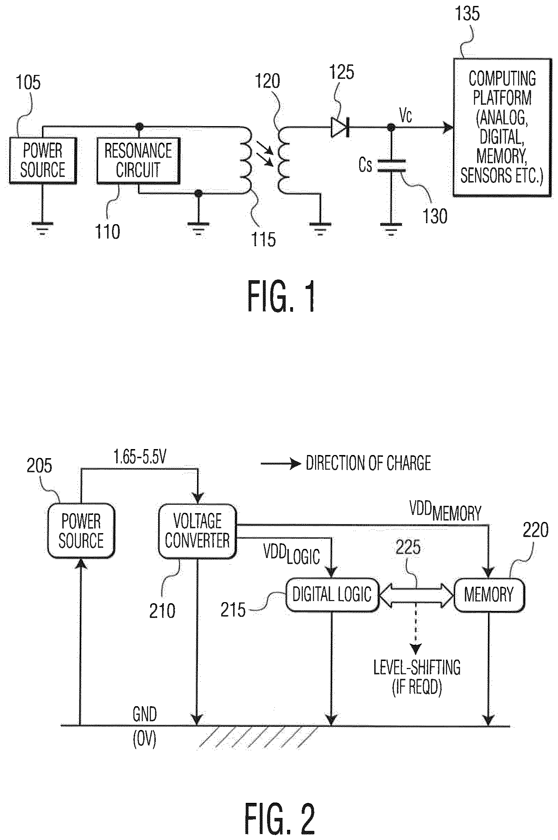

FIG. 1 illustrates a generic system using magnetic coupling to transfer wireless energy. The system 100 includes a power source 105, a resonance circuit 110, transmitter coils 115, receiver coils 120, a diode 125, capacitor 130, and a computing platform 135. The basic principle of operation is that the transmitter coils 115 set up a magnetic field that induces current in the receiver coils 120 to charge the capacitor 130. The power transmission part of the system include the power source 105, resonance circuit 110, and transmitting coils 115 to set up the electromagnetic field. The receiver portion of the system 100 is divided into a receiving coil 120, a rectifying circuit 125, and the capacitor 130 that acts as an energy storage device. The received energy is stored on the capacitor 130 which may then power the elements on the computing platform 135.

One main characteristic of the above described and similar systems is the non-static nature of energy availability from the energy source. Because of this, whenever possible, the wireless energy receiving system may capture the energy from the magnetic field and store it on the capacitor 130. This stored energy allows the system to continue to operate even when there is no magnetic field. This need for energy storage leads to various design requirements for the system and especially the capacitor 130. The size of the capacitor 130 is based on the energy consumption in the system. Often the capacitor 130 can take a significant area of the total silicon area of the system. It is also noted that the size of the capacitor 130 is strongly dependent on the amount of leakage current in the system. This leakage current consumes the charge stored on the capacitor 130 by the magnetic field.

Therefore, to limit the size of the capacitor 130 and its associated cost, it is very important to minimize the area of the capacitor 130. This may be done by minimizing the charge consumption in the system, especially during the static mode of operation where leakage currents can deplete the charge on the capacitor. This goal of the embodiments described below.

In the wirelessly powered system like that shown in FIG. 1 above, which may be for example a contactless smart card, the system needs to remain powered up for certain time duration even in the absence of energy field. For this purpose, energy stored in a capacitor is used to supply the system energy, which in the case of contactless smart cards is mainly static leakage. However, the amount of capacitance required to supply this energy for the given duration gets prohibitively high and is a main contributor to the area of the design. This leads to high silicon costs for the system.

FIG.2 illustrates a low power system that may be powered using a power source. The system 200 includes a power source 205, voltage converter 210, digital logic 215, memory 220, and level converter 225. The power source 205 may provide a supply voltage of, for example, 1.65-5.5V. It is noted that the power source may be a battery or an energy storage capacitor. On the other hand, the digital logic 215 and memory 220 needs to operate at a minimum allowed supply voltage which is typically lower than the power source supply voltage. For example, the memory voltage may be 1V.

Accordingly, the power source 205 produces a higher voltage than the digital logic 215 and the memory 220 uses. Thus a voltage converter 210 is needed to convert the power source voltage to a voltage used by the digital logic 215 and the memory 220. The voltage converter 215 takes up area and power. Low dropout regulators (LDOs) switching converters may be used for the voltage conversion. LDOs are simpler and smaller designs, but have lower efficiency of around 50-60%. Switching converters have a higher efficiency (>85%), but require more area and a more complex design. As a result many applications favor the use of an LDO, so the problem then becomes working with the lower efficiencies, but also less stringent constraints.

In the system topology illustrated in FIG. 2, the digital logic 215 and memory 220 consume the charge from the power source 205 for their operation. The charge and current requirements are the summation of individual charge requirements of the digital logic 215 and the memory 220. Also, the voltage converter 210 may have to produce two separate voltage levels, one for the digital logic 215 and one for the memory 220. This leads to further inefficiency in the voltage converter 210. Moreover, the security requirements on individual domains may require the placement of voltage sensors/monitors on logic and memory domains. This overhead of additional monitors often forces a designer to keep a single voltage domain for the logic and memory, thereby, reducing the energy efficiency of the design. Further, the current supplied by the power source 205 is the sum of the currents required by the digital logic 215 and the memory 220 that leads to increased conversion loss, because as current increases the a conduction and switching loss in the power converter 210 increases. Further, because the digital logic 215 and the memory 220 may operate at different voltage levels, level shifting may be required when the digital logic 215 communicates with the memory 220.

One solution to improve the system efficiency is circuit stacking where the digital logic and memory are stacked or connected in series with the power converter. This has the effect of reducing the current supplied to the stack and increases the voltage supplied to the stack. This results in increase converter efficiency thus reducing the power source requirements.

Traditionally, circuit stacking techniques are deployed by decomposing the system design into multiple-stacks. The stacks may be so-designed such that there is almost equal activity between different stack-levels. This ensures that the charge from one level is completely balanced by the requirement on the other level. The mismatch in the activities can be compensated using various techniques described below. However, the charge recycling usage is limited by the activity balancing and switching timing synchronization between different levels. This charge recycling during the dynamic phase dictates the design strategy and often makes systems very complicated.

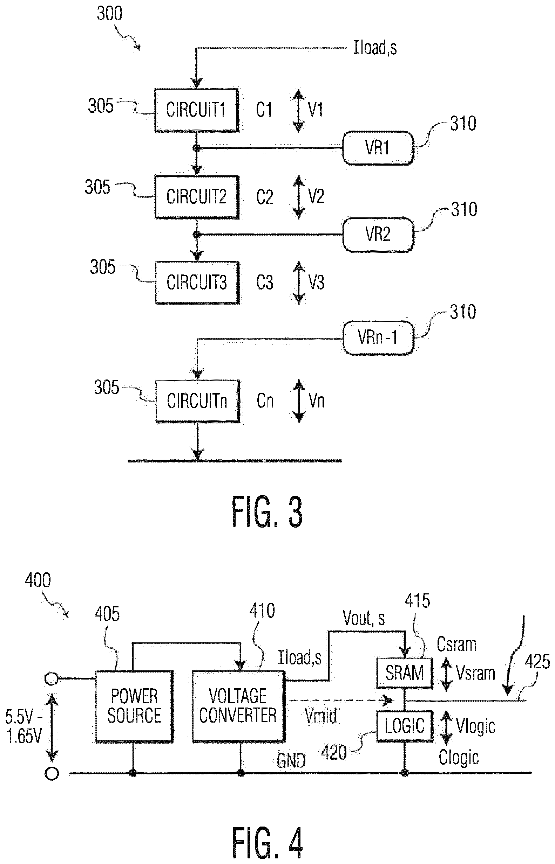

FIG. 3 illustrates a stacked circuit system according to the related art. The system 300 includes N stacked circuits 305 and N-1 voltage regulators 310. The N stacked circuits 305 are connected in series and receive a supply current I_{load,s}. Further, there is a voltage drop Vₙ across each stacked circuit. Accordingly a power supply may supply a voltage of V₁ + V₂ + ... V_{N} to the stacked circuits 305. As discussed above one of the challenges is balancing the charge across the circuits as the different circuits operation varies relative to one another. This causes the voltage levels between the various stacked circuits 305 to vary. The voltage regulators 310 regulate this voltage to compensate for charge imbalances between the stacked circuits 305. This solution adds cost and complexity to the design. This is especially undesirable in low power and low cost applications.

Two other solutions to charge balancing have been proposed in the related art. The first is using a software solution where a compiler and run-time scheduler are used to balance the operation of the stacked circuits 305. The second is clock throttling, where the clock speed of each stacked circuit 305 is adapted in order to adjust the current and power draw of each stacked circuit 305. Both of these solutions add cost and complexity. Further they still result in charge imbalances between the stacked circuits 305.

The embodiments of the invention described below decompose the system such that: charge recycling is dictated by the leakage mode, thereby, reducing the limitations of the traditional circuit stacking; decomposition of memory and logic such that logic can operate at minimally required voltage; voltage-sensors/monitors for only one domain to reduce the overhead on secure system, thereby, allowing the separate voltage domains for logic and memory. These features may lower the overall design costs and may make the system economically feasible.

To understand the embodiments described herein, it is important to realize that in a battery/capacitor operated design energy is consumed in the form of electrical charge moving from one place to another, *e*.*g*. between the terminals of the battery or the capacitor. The entities that drive the movement or this charge are mostly digital circuits that typically may include digital logic circuits and memories (*e*.*g*., RAM/ROM). Based on above observations with respect to decomposing the system, the charge-recycling between various parts of a digital circuitry may be implemented, such that same charge taken from the battery is reused for different tasks. This results in draining the battery at a slower pace than the conventional design techniques.

FIG. 4 illustrates a system that implements a charge-recycling between memory and digital circuits. The system 400 includes a power source 405, voltage converter 410, memory 415, digital logic 420, and a level shifter 425. The power source 405 may be a battery, capacitor or any other power source used to power digital circuitry. The voltage converter 410 is a DC-DC converter that converts the voltage from the power source 405 to a voltage to be used to power the memory 415 and the digital logic 420. The voltage converter may be any type of voltage converter, such as for example, an LDO or switching converter. The memory 415 includes the memory used by the system 400 and is shown as SRAM, but may be any type of memory needed by the system. The digital logic may include various types of digital circuitry including processors, signal processors, filters, multipliers, codecs, application specific integrated circuits (ASICs), clock generation unit, phase locked loops, other complimentary analog blocks, *etc.* used to carry out the functionality of the system 400. The combination of the memory 415 and the digital logic 420 may be called the stack. The level shifter 425 connects the memory 415 to the digital logic 420 and allows for the communication between the memory 415 and the digital logic 420. Because the memory 415 and the digital logic 420 are stacked, different voltage levels are used to implement the logic values in the memory 415 and the digital logic 420. The level shifter 425 converts the digital signals between the memory 415 and the digital circuit 420 so that the digital information is correctly communicated. This will be further described below.

The operation of the system 400 will now be described including a method for balancing the charge between the memory 415 and the digital logic 420. The power source 405 outputs a voltage and current to the power the memory 415 and the digital logic 420. The voltage produced by power sources 405 is typically larger than the voltage used by the memory 415 and the digital logic 420. For example, the voltage output of the power supply 405 may be in the range of about 1.65-5.5V, where the memory 415 and the digital logic 420 have operating voltages of <1.5 volts. The power source voltage may then be converted by the voltage converter 410 to the voltage required to drive the stack, which voltage is the combination of the voltage required to drive the memory 415 and the digital logic 420.

The memory 415 is placed at the top of the stack, which means that the memory 415 receives the supply current first. Placing the memory 415 at the top of the stack has an advantage that the leakage current from the memory may be used to drive the digital logic circuit 420. Memory cannot be turned off in order to preserve the stored data which results in a leakage current. This leakage current may be used to charge up a capacitance found in the digital logic 420. Also, when the memory 415 requires more current than the digital logic 420, excess charge may be stored in the digital logic 420. This stored charge may then be used to power the digital logic 420, when the memory 415 is idle. This results in a more balanced use of charge from the battery. Further, charge from the leakage current may be stored in the digital logic 420 to be used later, which reduces the overall draw on the power source 405.

The leakage current charge from the memory 415 may be stored in a capacitance found in the digital logic. This capacitance may be the capacitance inherent in the various transistors and devices found in the digital logic 420. Further, additional capacitance may be added to the digital logic 420 in order to increase the charge storage capacity. Also, additionally the leakage current may be stored in a capacitance in the voltage converter 410.

Further, the voltage converter may be connected to the node between the memory 415 and the digital logic 420. The voltage at this node should be kept at a desired voltage corresponding to the voltage drop across the memory 415 and the digital logic 420. The voltage converter monitors the voltage of at this node to determine if it is deviating from its desired value. If so, the voltage converter 410 may supply or sink current as needed in order to maintain the node voltage at its desired value. This provides additional capability to balance the charge in addition to the storage of leakage current charge in the digital logic 420.

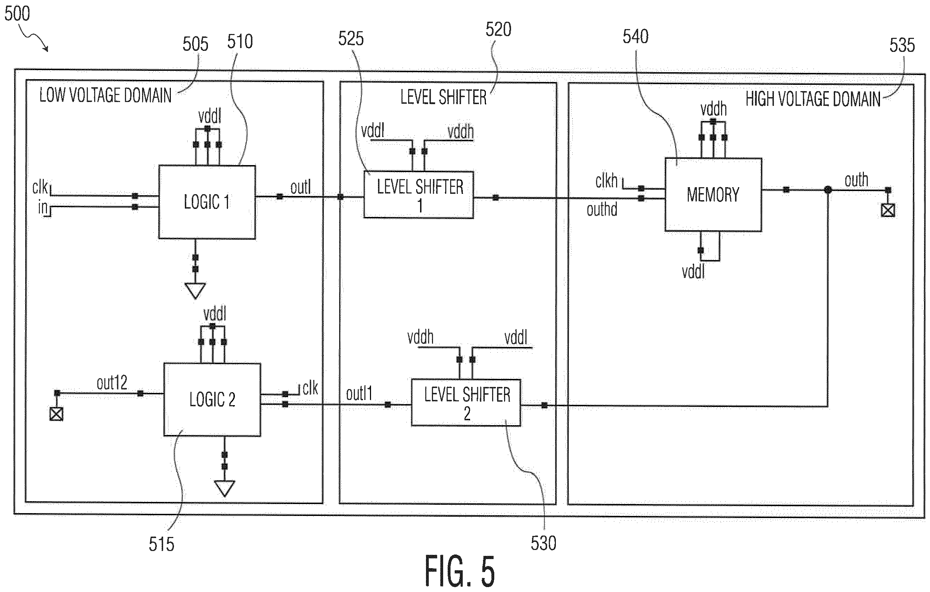

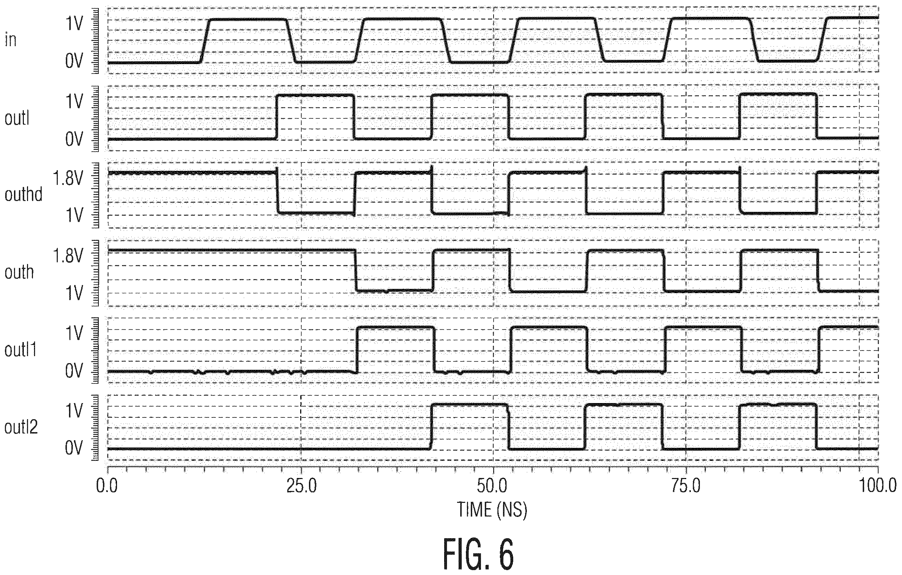

FIG. 5 illustrates a system with a level shifter. FIG. 6 illustrates the various inputs and outputs associated with the level shifter of FIG. 5. The system 500 includes a low voltage domain 505, a level shifter 520, and a high voltage domain 535. The low voltage domain 505 has a voltage range of 0-1.0 V, with, for example, a voltage of 0 V indicating a logic 0 and a voltage of 1.0V indicating a logic 1. The high voltage domain 535 has a voltage range of 1.0-1.8 V, with, for example, a voltage of 1.0 V indicating a logic 0 and a voltage of 1.8 V indicating a logic 1. The level shifter 520 shifts signals between the low voltage domain 505 and the high voltage domain 535. The low voltage domain 505 includes logic 1 510 and logic 2 515. The level shifter 520 include level shifter 1 525 and level shifter 2 530. The high voltage domain 535 includes memory 540. The logic 1 circuit 510 receives an input voltage in that leads to an output voltage outl. Level shifter 1 525 receives the voltage outl from the logic circuit 1 510 and provides a shifted output voltage outhd. The memory 540 receives the voltage outhd and produces an output voltage outh. Level shifter 2 530 receives the voltage outh and converts it to a voltage outl1. The logic 2 circuit 515 receives the voltage outl1 and produces a voltage out l2. FIG. 6 shows various signals used in the system named in, outl, outhd, outh, outl1, and outl2 as a function of voltage versus time. As the signal propagates between the low voltage domain 505 and the high voltage domain 535 via the level shifter 520, the level of the signals are shifted to correspond to the correct level for the logic level in each domain.

The embodiments described herein provide various benefits. As discussed above, during a leakage mode, the leakage of the memory (which is usually larger than that of the digital logic) is used to supply charge to the digital logic. This charge may also be stored in a capacitor in the digital logic or voltage converter. This means that there will be less charge drained from the battery. Stacking of the memory on top of the digital logic leads to a lower over all current draw from the voltage converter, but a higher output voltage from the voltage converter. This results in a higher efficiency in the voltage converter. For example, a voltage converter with a 65% voltage efficiency used to drive a memory and digital logic that are not stacked may increase to 85% when driving a stacked memory and digital logic.

Further, the system topology allows a single voltage-sensing between the two stack domains. This means that the voltage sensor overhead is reduced from the traditional approach of creating multiple supply voltages for each of the digital logic and memory. Also, the power management unit (PMU) overhead of creating separate power domain for logic and memory is also reduced.

It should be appreciated by those skilled in the art that any block diagrams herein represent conceptual views of illustrative circuitry embodying the principles of the invention. Further, in the circuits shown additional elements may also be included as needed, or variations to the structure of the circuit may be made to achieve the same functional results as the circuits illustrated.

Although the various exemplary embodiments have been described in detail with particular reference to certain exemplary aspects thereof, it should be understood that the invention is capable of other embodiments and its details are capable of modifications in various obvious respects. Accordingly, the foregoing disclosure, description, and figures are for illustrative purposes only and do not in any way limit the invention, which is defined only by the claims.

## Claims

1. A system comprising:
a voltage converter (210, 410) configured to convert a voltage from a power source (205, 405) to a different voltage;
a stack including a memory (220, 415) and a digital logic circuit (215, 420) wherein the memory is stacked on top of the digital logic circuit; and
a level shifter (225) coupled between the memory and digital logic circuit;
wherein the memory is coupled between the voltage converter and the digital logic circuit,
wherein leakage current from the memory is stored in a capacitance in the digital logic circuit,
wherein the voltage converter is further coupled to a node (425) between the memory and digital logic circuit, and
wherein the voltage converter is configured to:
monitor a voltage at the node wherein the node has a desired operating voltage value; and
adjust the voltage at the node when the voltage at the node varies from the desired operating voltage value.

2. The system of claim 1, further comprising a capacitor in the digital logic circuit configured to store leakage current from the memory.

3. The system of claim 1 or 2, further comprising a capacitor in the voltage converter configured to store leakage current from the memory.

4. The system of any preceding claim, wherein the voltage converter is a linear dropout regulator.

5. The system of any preceding claim, wherein the voltage converter is a switching regulator.

6. The system of any preceding claim, wherein adjusting the voltage at the node includes the voltage converter supplying current to the node or sinking current from the node.

7. A method of powering a low power system comprising:
converting an input DC voltage to an output voltage with a different level;
applying the output voltage to a stack including a memory (220, 415) and a digital logic circuit (215, 420) wherein the memory is stacked on top of the digital logic circuit;
level converting data signals between the memory and the digital logic circuit;
storing a leakage current from the memory in a capacitance in the digital logic circuitry;
monitoring a voltage at a node (425) between the memory and the digital logic circuit wherein the node has a desired operating voltage value; and
adjusting the voltage at the node when the voltage at the node varies from the desired operating voltage value.

8. The method of claim 7, further comprising storing leakage current in a capacitor in the digital logic circuit.

9. The method of claim 7 or 8, further comprising storing leakage current in a capacitor in the voltage converter.

10. The method of any one of claims 7 to 9, wherein a linear dropout regulator performs the voltage conversion.

11. The method of any one of claims 7 to 10, wherein a switching regulator performs the voltage conversion.

12. The method of any one of claims 7 to 11, wherein adjusting the voltage at the node includes supplying current to the node or sinking current from the node.

## Patentansprüche

1. Ein System aufweisend:
einen Spannungswandler (210, 410), der konfiguriert ist, eine Spannung von einer Leistungsquelle (205, 405) in eine andere Spannung umzuwandeln;
einen Stapel, der einen Speicher (220, 415) und eine digitale logische Schaltung (215, 420) umfasst, wobei der Speicher oben auf die digitale logische Schaltung gestapelt ist, und
einen Pegelumsetzer (225), der zwischen den Speicher und die digitale logische Schaltung gekoppelt ist,
wobei der Speicher zwischen den Spannungswandler und die digitale logische Schaltung gekoppelt ist,
wobei Leckstrom aus dem Speicher in einer Kapazität in der digitalen logischen Schaltung gespeichert wird,
wobei der Spannungswandler ferner gekoppelt ist an einen Knoten (425) zwischen dem Speicher und der digitalen logischen Schaltung, und
wobei der Spannungswandler konfiguriert ist:
zu überwachen eine Spannung an dem Knoten, wobei der Knoten einen gewünschten Betriebsspannung Wert hat; und
anzupassen die Spannung an dem Knoten, wenn die Spannung an dem Knoten von dem gewünschten Betriebsspannung Wert abweicht.

2. Das System gemäß Anspruch 1, ferner aufweisend einen Kondensator in der digitalen logischen Schaltung, der konfiguriert ist, Leckstrom aus dem Speicher zu speichern.

3. Das System gemäß Anspruch 1 oder 2, ferner aufweisend einen Kondensator in dem Spannungswandler, der konfiguriert ist, Leckstrom aus dem Speicher zu speichern.

4. Das System gemäß einem vorherigen Anspruch, wobei der Spannungswandler ein linearer Dropout Regler ist.

5. Das System gemäß einem vorherigen Anspruch, wobei der Spannungswandler ein Schaltregler ist.

6. Das System gemäß einem vorherigen Anspruch, wobei das Anpassen der Spannung an dem Knoten umfasst, dass der Spannungswandler Strom an den Knoten bereitstellt oder Strom von dem Knoten abzieht.

7. Ein Verfahren zum Versorgen eines Niedrigleistung Systems aufweisend:
Umwandeln einer Eingang Gleichspannung in eine Ausgangsspannung mit einem unterschiedlichen Pegel;
Anlegen der Ausgangsspannung an einen Stapel, der einen Speicher (220, 415) und eine digitale logische Schaltung (215, 420) umfasst, wobei der Speicher oben auf die digitale logische Schaltung gestapelt ist;
Pegelwandeln von Datensignalen zwischen dem Speicher und der digitalen logischen Schaltung;
Speichern eines Leckstroms aus dem Speicher in einer Kapazität in der digitalen logischen Schaltung;
Überwachen einer Spannung an einem Knoten (425) zwischen dem Speicher und der digitalen logischen Schaltung, wobei der Knoten einen erwünschten Betriebsspannung Wert hat; und
Anpassen der Spannung an dem Knoten, wenn die Spannung an dem Knoten von dem erwünschten Betriebsspannung Wert abweicht.

8. Das Verfahren gemäß Anspruch 7, ferner aufweisend ein Speichern des Leckstroms in einem Kondensator in der digitalen logischen Schaltung.

9. Das Verfahren gemäß Anspruch 7 oder 8, ferner aufweisend ein Speichern des Leckstroms in einem Kondensator in dem Spannungswandler.

10. Das Verfahren gemäß einem der Ansprüche 7 bis 9, wobei ein linearer Dropout Regler die Spannungsumwandlung durchführt.

11. Das Verfahren gemäß einem der Ansprüche 7 bis 10, wobei ein Schaltregler die Spannungsumwandlung durchführt.

12. Das Verfahren gemäß einem der Ansprüche 7 bis 11, wobei das Anpassen der Spannung an dem Knoten umfasst ein Bereitstellen von Strom an den Knoten oder ein Abziehen von Strom aus dem Knoten.

## Revendications

1. Système, comprenant :
un convertisseur de tension (210, 410), configuré pour convertir une tension d'une source d'énergie (205, 405) en une tension différente ;
un empilement comprenant une mémoire (220, 415) et un circuit logique numérique (215, 420), la mémoire étant empilée sur le circuit logique numérique ; et
un dispositif de décalage de niveau (225) couplé entre la mémoire et le circuit logique numérique ;
dans lequel la mémoire est couplée entre le convertisseur de tension et le circuit logique numérique,
dans lequel un courant de fuite de la mémoire est stocké dans une capacité dans le circuit logique numérique,
dans lequel le convertisseur de tension est en outre couplé à un noeud (425) entre la mémoire et le circuit logique numérique, et
dans lequel le convertisseur de tension est configuré pour :
surveiller une tension au niveau du noeud, le noeud présentant une valeur de tension de service souhaitée ; et
ajuster la tension au niveau du noeud lorsque la tension au niveau du noeud varie par rapport à la valeur de tension de service souhaitée.

2. Système selon la revendication 1, comprenant en outre un condensateur dans le circuit logique numérique configuré pour stocker un courant de fuite de la mémoire.

3. Système selon la revendication 1 ou 2, comprenant en outre un condensateur dans le convertisseur de tension configuré pour stocker un courant de fuite de la mémoire.

4. Système selon l'une quelconque des revendications précédentes, dans lequel le convertisseur de tension est un régulateur à chute de tension linéaire.

5. Système selon l'une quelconque des revendications précédentes, dans lequel le convertisseur de tension est un régulateur à découpage.

6. Système selon l'une quelconque des revendications précédentes, dans lequel l'ajustement de la tension au niveau du noeud comprend le fait que le convertisseur de tension fournit un courant au noeud ou absorbe un courant issu du noeud.

7. Procédé d'alimentation d'un système à faible puissance, comprenant les étapes consistant à :
convertir une tension CC d'entrée en une tension de sortie avec un niveau différent ;
appliquer la tension de sortie à un empilement comprenant une mémoire (220, 415) et un circuit logique numérique (215, 420), la mémoire étant empilée sur le circuit logique numérique ;
décaler le niveau de signaux de données entre la mémoire et le circuit logique numérique ;
stocker un courant de fuite de la mémoire dans une capacité dans les circuits logiques numériques ;
surveiller une tension au niveau d'un noeud (425) entre la mémoire et le circuit logique numérique, le noeud présentant une valeur de tension de service souhaitée ; et
ajuster la tension au niveau du noeud lorsque la tension au niveau du noeud varie par rapport à la valeur de tension de service souhaitée.

8. Procédé selon la revendication 7, comprenant en outre le stockage d'un courant de fuite dans une capacité dans le circuit logique numérique.

9. Procédé selon la revendication 7 ou 8, comprenant en outre le stockage d'un courant de fuite dans une capacité dans le convertisseur de tension.

10. Procédé selon l'une quelconque des revendications précédentes 7 à 9, dans lequel un régulateur à chute de tension linéaire effectue la conversion de tension.

11. Procédé selon l'une quelconque des revendications 7 à 10, dans lequel un régulateur à découpage effectue la conversion de tension.

12. Procédé selon l'une quelconque des revendications 7 à 11, dans lequel l'ajustement de la tension au niveau du noeud comprend la fourniture de courant au noeud ou l'absorption de courant issu du noeud.
